# EUROPEAN PATENT APPLICATION

(11) **EP 4 517 822 A1**
(43) Date of publication of application: **05.03.2025**
(21) Application number: 24769813.7
(22) Date of filing: 06.03.2024
(51) Int. Cl.: H01L 23/538, H01L 21/336, H01L 21/768

(54) **SEMICONDUCTOR STRUCTURE AND MANUFACTURING METHOD THEREFOR**

(30) Priority: 14.03.2023 CN 202310240331; 16.03.2023 CN 202310275779
(71) Applicant: CXMT Corporation, Hefei City, Anhui Province 230601 (CN)
(72) Inventor: LIU, Xiang, Hefei, Anhui 230601 (CN)
(74) Representative: Gulde & Partner
(86) International application number: PCT/CN2024/080251
(87) International publication number: WO 2024/188120

(57) **Abstract**

This application relates to a semiconductor structure and a manufacturing method therefor. The semiconductor structure includes multiple semiconductor pillars arranged in rows and spaced apart in a first direction and multiple word lines extending in the second direction and being spaced apart in the first direction. The multiple word lines and the multiple semiconductor pillars are alternately arranged in the first direction, and two word lines located on two opposite sidewalls of the same semiconductor pillar are staggered in an extension direction of the semiconductor pillar, and jointly constitute a control word line corresponding to the semiconductor pillar. The semiconductor structure can reduce the volume of a device and reduce the difficulty of a manufacturing process.

## Description

### CROSS-REFERENCE TO RELATED APPLICATIONS

This application refers to Chinese Patent Application No. 202310240331.1, filed on March 14, 2023 and entitled "SEMICONDUCTOR STRUCTURE AND MANUFACTURING METHOD THEREFOR" and Chinese Patent Application No. 202310275779.7, filed on March 16, 2023 and entitled " SEMICONDUCTOR STRUCTURE AND MANUFACTURING METHOD THEREFOR", which are incorporated herein by reference in their entireties.

### TECHNICAL FIELD

This application relates to the field of integrated circuit technologies, and in particular, to a semiconductor structure and a manufacturing method therefor.

### BACKGROUND

With the development of a dynamic random access memory (DRAM) technology, the size of a storage cell has been decreasing, and an array architecture of the storage cell evolves from 8F² to 6F² and then to 4F²(F is a minimum pattern size available under a given process condition).

However, in a structure designed by 4F², how to minimize the area of a transistor in a single array region to pursue higher chip area utilization is still a problem that urgently needs to be resolved at present.

### SUMMARY

In view of this, this application provides a semiconductor structure and a manufacturing method therefor, to reduce the volume of a device and reduce the difficulty of a manufacturing process.

According to an aspect, this application provides a semiconductor structure according to some embodiments, including:
multiple semiconductor pillars arranged in rows and spaced apart in a first direction; and
multiple word lines extending in a second direction and being spaced apart in the first direction, the second direction intersecting the first direction.

The multiple word lines and the multiple semiconductor pillars are alternately arranged in the first direction, and two word lines located on two opposite sidewalls of the same semiconductor pillar are staggered in an extension direction of the semiconductor pillar, and jointly constitute a control word line corresponding to the semiconductor pillar.

In some embodiments, the semiconductor structure includes a semiconductor layer having first isolation trenches extending in the first direction and second isolation trenches extending in the second direction. The depth of the first isolation trench is greater than the depth of the second isolation trench, the second direction intersects the first direction, the first isolation trenches isolate multiple semiconductor strips spaced apart in the second direction in the semiconductor layer, and the second isolation trenches isolate multiple semiconductor pillars spaced apart in the first direction in the semiconductor strips.

In some embodiments, the semiconductor pillar includes a channel region and a first doped region and a second doped region respectively disposed at the upper end and the lower end of the channel region in the extension direction of the semiconductor pillar.

In some embodiments, the two word lines located on two sides of the same semiconductor pillar are respectively located on sidewalls of the channel region, and projections of the two word lines in the channel region toward the substrate do not overlap.

In some embodiments, in the two word lines corresponding to the same semiconductor pillar, a word line close to a bottom portion of the second isolation trench is a second word line, and a word line away from the bottom portion of the second isolation trench is a first word line. A top surface of the second word line is flush with or lower than a bottom surface of the first word line.

In some embodiments, the channel region includes:
a first channel close to the first doped region or at least partially connected to the first doped region, the first word line being located on a first-side sidewall of the first channel, and a part of the first channel close to the first-side sidewall being capable of forming a first inversion layer in response to an electrical signal of the first word line;
a second channel close to the second doped region or at least partially connected to the second doped region, the second word line being located on a second-side sidewall of the first channel, a part of the second channel close to the second-side sidewall being capable of forming a second inversion layer in response to an electrical signal of the second word line, and the second channel not overlapping the first channel; and
an isolation channel located between the first channel and the second channel and configured to isolate the first inversion layer and the second inversion layer.

In some embodiments, there is a spacing between adjacent projection boundary lines, in the channel region toward the substrate, of the two word lines located on the two sides of the same semiconductor pillar.

In some embodiments, an extension direction of the isolation channel is parallel to the first direction.

In some embodiments, the isolation channel is located between a projection of the first word line in the channel region toward the substrate and a projection of the second word line in the channel region toward the substrate.

In some embodiments, the isolation channel overlaps the projection of the first word line in the channel region toward the substrate and/or the projection of the second word line in the channel region toward the substrate.

In some embodiments, the extension direction of the isolation channel intersects the first direction.

In some embodiments, the isolation channel includes a first-side end surface and a second-side end surface disposed opposite to each other in the extension direction of the isolation channel.

The first-side end surface is located on a side of the first channel close to the second channel, and the first-side end surface is located outside the projection of the first word line in the channel region toward the substrate.

The second-side end surface is located on a side of the second channel close to the first channel, and the second-side end surface is located outside the projection of the second word line in the channel region toward the substrate.

In some embodiments, a doping type of a semiconductor pillar in which the first channel is located, a doping type of a semiconductor pillar in which the second channel is located, and a doping type of a semiconductor pillar in which the isolation channel is located are the same. A doping concentration of the semiconductor pillar in which the isolation channel is located is less than a doping concentration of the semiconductor pillar in which the first channel is located and less than a doping concentration of the semiconductor pillar in which the second channel is located.

In some embodiments, the width of the second word line increases in a direction away from the bottom portion of the second isolation trench, and the width of the second word line is the size of the second word line in the first direction.

In some embodiments, the shape of an end portion of the second word line close to the bottom portion of the second isolation trench is similar to that of the bottom portion of the second isolation trench.

In some embodiments, the semiconductor structure further includes an air gap structure located in the second isolation trench.

The air gap structure includes:
a first air gap located above the second word line; and/or
a second air gap located below the first word line.

In some embodiments, the semiconductor structure further includes:
a first isolation structure located in the first isolation trench and filling a spacing between adjacent semiconductor strips; and
a second isolation structure located in the second isolation trench and filling a spacing between adjacent semiconductor pillars in the first direction and covering the word line, the second isolation structure further sealing the air gap structure.

In some embodiments, a bottom surface of the first air gap is flush with or lower than the bottom surface of the first word line, and a top surface of the first air gap is flush with or higher than a top surface of the first word line; and
a top surface of the second air gap is flush with or higher than the top surface of the second word line, and a bottom surface of the second air gap is flush with a bottom surface of the second word line.

The semiconductor structure further includes:
multiple bit lines extending in the first direction and being spaced apart, the bit lines being located on bottom surfaces of semiconductor pillars in a corresponding row and being connected to the semiconductor pillars.

In some embodiments, an orthographic projection of the bit line on the semiconductor layer overlaps or approximately overlaps the semiconductor strip.

The semiconductor structure further includes:
a bit line contact structure located between the bit line and the semiconductor strip.

The semiconductor strip is connected to the bit line through the bit line contact structure.

In some embodiments, the semiconductor structure further includes:
a gate dielectric layer covering a sidewall of the semiconductor pillar in the first direction and being located between the semiconductor pillar and the word line.

According to another aspect, this application further provides a manufacturing method for a semiconductor structure according to some embodiments, including the steps as follows.

A semiconductor layer is provided, and first isolation trenches extending in a first direction and second isolation trenches extending in a second direction are formed in the semiconductor layer. The depth of the first isolation trench is greater than the depth of the second isolation trench, the second direction intersects the first direction, the first isolation trenches isolate multiple semiconductor strips spaced apart in the second direction in the semiconductor layer, and the second isolation trenches isolate multiple semiconductor pillars spaced apart in the first direction in the semiconductor strips.

Bit lines extending in the first direction are respectively formed on bottom surfaces of the multiple semiconductor strips.

Word lines extending in the second direction are respectively formed in the multiple second isolation trenches. The multiple word lines and the multiple semiconductor pillars are alternately arranged in the first direction, and two word lines located on two opposite sidewalls of the same semiconductor pillar are staggered in an extension direction of the semiconductor pillar, and jointly constitute a control word line corresponding to the semiconductor pillar.

In some embodiments, the semiconductor pillar includes a channel region and a first doped region and a second doped region respectively disposed at the upper end and the lower end of the channel region in the extension direction.

That word lines extending in the second direction are formed in the multiple second isolation trenches includes the steps as follows.

The first word line is formed on a partial sidewall of the channel region close to the first doped region.

The second word line is formed on a partial sidewall of the channel region close to the second doped region.

The channel region includes a first channel close to the first doped region and connected to the first doped region and a second channel located between the first channel and the second doped region and connected to the second doped region. The second channel does not overlap the first channel.

That the first word line is formed on a surface of a partial sidewall of the channel region close to the first doped region includes the step as follows. The first word line is formed on a first-side sidewall of the first channel. A part of the first channel close to the first-side sidewall is capable of forming a first inversion layer in response to an electrical signal of the first word line.

That the second word line is formed on a partial sidewall of the channel region close to the second doped region includes the step as follows. The second word line is formed on a second-side sidewall of the second channel. A part of the second channel close to the second-side sidewall is capable of forming a second inversion layer in response to an electrical signal of the second word line.

In some embodiments, in the two word lines corresponding to the same semiconductor pillar, a word line close to a bottom portion of the second isolation trench is a second word line, and a word line away from the bottom portion of the second isolation trench is a first word line.

That word lines extending in the second direction are respectively formed in the multiple second isolation trenches includes the steps as follows.

Second word lines are respectively formed on bottom portions of some of the second isolation trenches.

First word lines are respectively formed on upper middle portions of the other second isolation trenches.

A top surface of the second word line is flush with or lower than a bottom surface of the first word line.

In some embodiments, before the second isolation trenches are formed in the semiconductor layer, the manufacturing method for a semiconductor structure further includes the step as follows. A first isolation structure is formed in the first isolation trench. The first isolation structure fills a spacing between adjacent semiconductor strips.

After the word lines are formed in the second isolation trenches, the manufacturing method for a semiconductor structure further includes the step as follows. A second isolation structure is formed in the second isolation trench. The second isolation structure fills a spacing between adjacent semiconductor pillars in the first direction and covers the word line.

In some embodiments, that a second isolation structure is formed in the second isolation trench includes the steps as follows.

A first air gap is formed above the second word line.

A second air gap is formed below the first word line.

The first air gap and the second air gap jointly constitute an air gap structure, and the second isolation structure further seals the air gap structure.

In some embodiments, before the bit lines extending in the first direction are respectively formed on the bottom surfaces of the multiple semiconductor strips, the manufacturing method for a semiconductor structure further includes the step as follows.

Bit line contact structures extending in the first direction are respectively formed on the bottom surfaces of the multiple semiconductor strips.

The bit line is formed on a bottom surface of the bit line contact structure.

In some embodiments, before the word lines extending in the second direction are respectively formed in the multiple second isolation trenches, the manufacturing method for a semiconductor structure further includes the step as follows.

A gate dielectric layer covering a sidewall of the semiconductor pillar in the first direction is formed.

The word line is formed on a sidewall of the gate dielectric layer away from the semiconductor pillar.

The semiconductor structure and the manufacturing method therefor provided in this application have at least the following beneficial effects:

According to the semiconductor structure and the manufacturing method therefor provided in this application, two staggered word lines are formed on two opposite sidewalls of the semiconductor pillar while the two word lines are enabled to jointly constitute a control word line corresponding to the semiconductor pillar, so that space between adjacent semiconductor pillars can be reduced, thereby reducing the volume of a device. In addition, ends of the semiconductor pillars connected to the bit lines are shorted together, so that the volume of the device can be further reduced, and a contact resistance between the bit line and the semiconductor pillar can also be reduced. In addition, the second isolation trench in the semiconductor structure and the manufacturing method therefor provided in this application is shallower than a trench in a conventional semiconductor structure. Therefore, the difficulty of a manufacturing process can be further reduced.

### BRIEF DESCRIPTION OF DRAWINGS

To describe the technical solutions in the embodiments of this application or the conventional technologies more clearly, the following briefly describes the accompanying drawings required for describing the embodiments or the conventional technologies. Clearly, the accompanying drawings in the following description show merely some embodiments of this application, and a person of ordinary skill in the art may still derive other drawings from these accompanying drawings without creative efforts.
FIG. 1a is a schematic diagram of a cross-sectional structure of a semiconductor structure according to some embodiments of this application; and FIG. 1b is a schematic top view of FIG. 1a;
FIG. 2a is a schematic diagram of a three-dimensional structure of a semiconductor structure according to some embodiments of this application; FIG. 2b is a schematic top view of FIG. 2a; FIG. 2c is a schematic main view of FIG. 2a; and FIG. 2d is a schematic diagram of a cross-sectional structure of FIG. 2a;
FIG. 3 is a partial schematic diagram of a semiconductor structure according to some embodiments of this application;
FIG. 4a is a partial schematic diagram of a semiconductor structure according to some other embodiments of this application; FIG. 4b is a partial schematic diagram of a semiconductor structure according to some still other embodiments of this application; and FIG. 4c is a partial schematic diagram of a semiconductor structure according to some yet other embodiments of this application;
FIG. 5a is a schematic diagram of a three-dimensional structure of a semiconductor structure according to some other embodiments of this application; and FIG. 5b is a schematic view of a cross-sectional structure of the structure shown in FIG. 5a;
FIG. 6 is a schematic diagram of a three-dimensional structure of a semiconductor structure according to some other embodiments of this application;
FIG. 7a is a schematic diagram of a cross-sectional structure of a semiconductor structure when a first word line and a second word line on the left side are swept according to some embodiments of this application; and FIG. 7b is a voltage-current diagram of the structure shown in FIG. 7a;
FIG. 8 is a schematic flowchart of a manufacturing method for a semiconductor structure according to some embodiments of this application;
FIG. 9 is a schematic flowchart of the step of S200 in a manufacturing method for a semiconductor structure according to some embodiments of this application;
FIG. 10 is a schematic flowchart of a manufacturing method for a semiconductor structure according to some other embodiments of this application;
FIG. 11 is a schematic flowchart of the step of S300 in a manufacturing method for a semiconductor structure according to some other embodiments of this application;
FIG. 12 is a schematic flowchart of forming a second isolation structure in a second isolation trench in a manufacturing method for a semiconductor structure according to some other embodiments of this application;
FIG. 13a is a schematic diagram of a three-dimensional structure of a structure obtained after a first isolation trench is formed in a manufacturing method for a semiconductor structure according to some embodiments of this application; FIG. 13b is a schematic diagram of a top-view structure of the structure shown in FIG. 13a; and FIG. 13c is a schematic diagram of a three-dimensional structure of a structure obtained after a first isolation structure is formed in a manufacturing method for a semiconductor structure according to some embodiments of this application;
FIG. 14a is a schematic diagram of a three-dimensional structure of a structure obtained after a second isolation trench is formed in a manufacturing method for a semiconductor structure according to some embodiments of this application; FIG. 14b is a schematic diagram of a top-view structure of the structure shown in FIG. 14a; and FIG. 14c is a schematic diagram of a three-dimensional structure of a structure obtained after a gate dielectric layer is formed in a manufacturing method according to some embodiments of this application;
FIG. 15a is a schematic diagram of a three-dimensional structure of a structure obtained in the step of S300 in a manufacturing method for a semiconductor structure according to some embodiments of this application; FIG. 15b is a schematic diagram of a top-view structure of the structure shown in FIG. 15a; and FIG. 15c is a schematic diagram of a three-dimensional structure of a structure obtained after a second isolation structure is formed in a manufacturing method for a semiconductor structure according to some embodiments of this application; and
FIG. 16 is a schematic diagram of a cross-sectional structure of a structure obtained after a bit line contact structure is formed in a manufacturing method for a semiconductor structure according to some embodiments of this application.

Descriptions of reference numerals:
T1. first isolation trench; T2. second isolation trench;
100. semiconductor layer; 10. semiconductor strip; 1. semiconductor pillar; 11. first doped region; 12. second doped region; 13. channel region; 131. first channel; 132. second channel; 133. isolation channel; 141. first inversion layer; 142. second inversion layer; 2. word line; 21. first word line; 21A. first word line located on the left side; 21B. first word line located on the right side; 22. second word line; 3. bit line; 4. bit line contact structure; 51. first isolation structure; 52. second isolation structure; 6. storage node contact structure; 7. air gap structure; 71. first air gap; 72. second air gap; 8. gate dielectric layer; NC. storage node of a device on the left side; NC0. storage node of a device on the right side.

### DESCRIPTION OF EMBODIMENTS

For ease of understanding of this application, this application is described more comprehensively below with reference to related accompanying drawings. A preferred embodiment of this application is provided in the accompanying drawings. However, this application may be implemented in many different forms, and is not limited to the embodiments described herein. Instead, these embodiments are provided to make the content of this application more thorough and comprehensive.

Unless otherwise defined, all technical and scientific terms used in this specification have meanings the same as those commonly understood by a person skilled in the art of this application. In this application, terms used in the specification of this application are merely intended to describe objectives of specific embodiments, but are not intended to limit this application.

It should be understood that an element or a layer may be directly on or adjacent to another element or layer or there may be an intermediate element or layer when the element or the layer is referred to as "on..." or "adjacent to... ". It should be understood that although the terms "first", "second", and the like may be utilized to describe various elements, components, regions, layers, doping types, and/or portions, these elements, components, regions, layers, doping types, and/or portions should not be limited by these terms. These terms are merely utilized to distinguish one element, component, region, layer, doping type, or portion from another element, component, region, layer, doping type, or portion. Therefore, without departing from the teachings of this application, a first element, component, region, layer, doping type, or portion discussed below may be represented as a second element, component, region, layer, or portion. For example, a first isolation trench may be referred to as a second isolation trench, and similarly, a second isolation trench may be referred to as a first isolation trench. The first isolation trench and the second isolation trench are different isolation trenches.

Spatial relationship terms, e.g., "below" and "above", may be utilized herein to describe a relationship between one element or a feature and another element or feature shown in the figures. It should be understood that in addition to the orientations shown in the figures, the spatial relationship terms further include different orientations of devices in use and operation. For example, an element or a feature described as "below..." is oriented to be "above" another element or feature if the devices in the accompanying drawings are flipped. Therefore, the example term "below" may include two orientations of being above and being below. In addition, the devices may alternatively be otherwise oriented (rotated by 90 degrees or oriented in another manner), and the spatial descriptors utilized herein are interpreted accordingly.

As utilized herein, the singular forms "a/an", "one", and "the" may also include plural forms unless otherwise clearly indicated in the context. It should also be understood that the presence of the feature, integer, step, operation, element, and/or component can be determined without ruling out the presence or addition of one or more other features, integers, steps, operations, elements, components, and/or groups when the term "constitute" and/or the term "include" are/is utilized in the specification. Moreover, as utilized herein, the term "and/or" includes any and all combinations of the related items listed.

The embodiments of the invention are described herein with reference to a cross-sectional view serving as a schematic diagram of an ideal embodiment (and an intermediate structure) of this application. In this way, a variation in the shown shape caused by, e.g., a manufacturing technology and/or a tolerance can be expected. Therefore, the embodiments of this application should not be limited to specific shapes of the regions shown herein, but include a shape deviation caused by, e.g., a manufacturing technology. The regions shown in the figure are essentially examples. The shapes of the regions do not represent actual shapes of the regions of the device, and do not limit the scope of this application.

Based on the disadvantages in the conventional technologies, this application provides a semiconductor structure and a manufacturing method therefor, to reduce the volume of a device and reduce the difficulty of a manufacturing process. Details of the semiconductor structure and the manufacturing method therefor are described in subsequent embodiments.

According to an aspect, this application provides a semiconductor structure according to some embodiments.

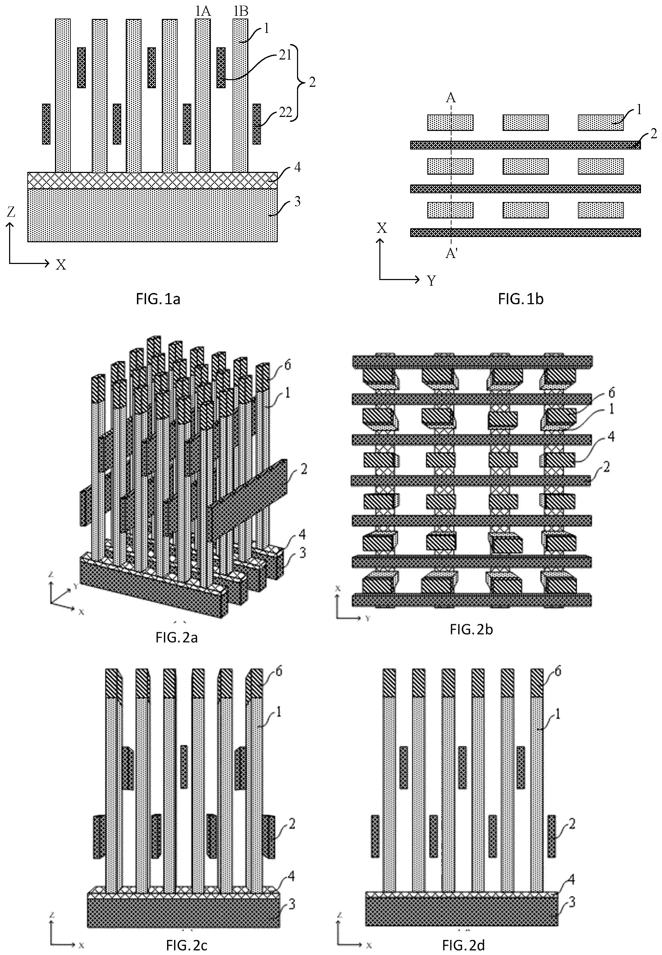

Referring to FIG. 1 and FIG. 2, in some embodiments, the semiconductor structure may include multiple semiconductor pillars 1 and multiple word lines 2. It should be noted that, to more clearly illustrate a location relationship between the semiconductor pillar 1 and the word line 2, other filling structures in the semiconductor structure are omitted in FIG. 1, FIG. 2a, FIG. 2b, FIG. 2c, and FIG. 2d. In an actual embodiment, the semiconductor structure may be further filled with another filling structure.

As shown in FIG. 1 and FIG. 2, the multiple semiconductor pillars 1 may be arranged in rows and spaced apart in a first direction (e.g., an X direction). Correspondingly, the multiple word lines 2 may extend in a second direction (e.g., a Y direction) and be spaced apart. It should be noted that in this embodiment of this application, the second direction should intersect the first direction.

The multiple word lines 2 and the multiple semiconductor pillars 1 may be alternately arranged in the first direction (e.g., the X direction), and two word lines 2 located on two sides of the same semiconductor pillar 1 may be staggered in an extension direction of the semiconductor pillar 1, and jointly constitute a control word line corresponding to the semiconductor pillar 1.

In the semiconductor structure provided in the foregoing embodiment, there are two staggered word lines 2 on two opposite sidewalls of the semiconductor pillar 1 while the two word lines 2 are enabled to jointly constitute a control word line corresponding to the semiconductor pillar 1, so that space between adjacent semiconductor pillars 1 can be reduced, thereby reducing the volume of a device.

The material of the semiconductor pillar 1 is not specifically limited in this application. In an example, the material of the semiconductor pillar 1 may include silicon (Si), silicon germanium (SiGe), silicon germanium carbon (SiGeC), silicon carbide (SiC), gallium arsenide (GaAs), indium arsenide (InAs), indium phosphide (InP), or another III/V semiconductor material or II/VI semiconductor material.

The material of the word line 2 is not specifically limited in this application, either. In an example, the material of the word line 2 may include but is not limited to a metal material. For example, the material of the word line 2 may include metal tungsten (Tungsten).

For ease of description, reference is made to FIG. 1a. In this embodiment of this application, two word lines 2 located on two sides of the same semiconductor pillar 1 may be defined as a first word line 21 and a second word line 22 respectively, and the first word line 21 and the second word line 22 located on the two sides of the same semiconductor pillar 1 may jointly constitute a control word line corresponding to the semiconductor pillar 1.

Specifically, in the semiconductor structure provided in the foregoing embodiment, adjacent semiconductor pillars 1 may share the same first word line 21 or second word line 22 while the first word line 21 or the second word line 22 is enabled to be a part of a control word line corresponding to the semiconductor pillars 1, so that space between adjacent semiconductor pillars 1 can be reduced, thereby reducing the volume of the device.

In addition, the disposition manner in which adjacent semiconductor pillars 1 share the same first word line 21 or second word line 22 can further make the internal layout of the semiconductor structure more proper, so that the storage density of the semiconductor structure is effectively increased.

Reference is made to FIG. 1a for understanding. In the semiconductor structure provided in the foregoing embodiment, adjacent semiconductor pillars 1 may share the same first word line 21 or second word line 22.

For example, in the semiconductor structure shown in FIG. 1a, two adjacent semiconductor pillars 1 (shown as a semiconductor pillar 1A and a semiconductor pillar 1B) in the first direction (e.g., the X direction) may share a first word line 21 located between the semiconductor pillar 1A and the semiconductor pillar 1B.

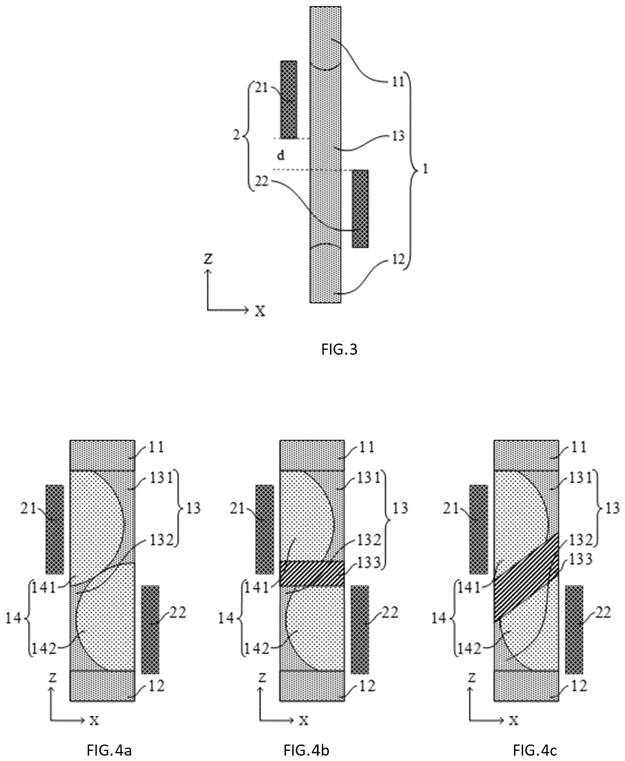

Referring to FIG. 3, in some embodiments, the semiconductor pillar 1 may specifically include a first doped region 11, a second doped region 12, and a channel region 13. The first doped region 11 and the second doped region 12 may be respectively disposed at the upper end and the lower end of the channel region 13 in an extension direction (e.g., a Z direction) of the channel region 13.

Neither a doping type of the first doped region 11 nor a doping type of the second doped region 12 is specifically limited in this application. In some embodiments, the doping type of the first doped region 11 and the doping type of the second doped region 12 each may be N-type doping.

In an example, as shown in FIG. 3, the two word lines 2 located on the two sides of the same semiconductor pillar 1 may be respectively disposed on sidewalls of the channel region 13.

A location relationship between the two word lines 2 located on the two sides of the same semiconductor pillar 1 is not specifically limited in this application. Further referring to FIG. 3, in some embodiments, projections of the two word lines 2 located on the two sides of the same semiconductor pillar 1 in the channel region 13 toward the substrate do not overlap.

Further referring to FIG. 3, in some embodiments, there may be a spacing d between adjacent projection boundary lines, in the channel region 13 toward the substrate, of the two word lines 2 located on the two sides of the same semiconductor pillar 1.

Referring to FIG. 4a, FIG. 4b, and FIG. 4c, in some embodiments, the channel region 13 may specifically include a first channel 131 and a second channel 132.

The first channel 131 is close to the first doped region 11 or at least partially connected to the first doped region 11. The first word line 21 is located on a first-side sidewall of the first channel 131, and a part of the first channel 131 close to the first-side sidewall is capable of forming a first inversion layer 141 in response to an electrical signal of the first word line 21. The second channel 132 is close to the second doped region 12 or at least partially connected to the second doped region 12. The second word line 22 is located on a second-side sidewall of the first channel 131, and a part of the second channel 132 close to the second-side sidewall is capable of forming a second inversion layer 142 in response to an electrical signal of the second word line 22. In addition, the first channel 131 may not overlap the second channel 132.

It should be noted that both the first inversion layer 141 and the second inversion layer 142 are inversion layers (Inversion layer). The inversion layer refers to a region in which a free carrier is opposite to a semiconductor carrier formed by doping under the action of an electric field generated by an electrical signal. The inversion layer may also be referred to as a conductive channel.

Neither a doping type of a semiconductor pillar 1 in which the first channel 131 is located nor a doping type of a semiconductor pillar 1 in which the second channel 132 is located is specifically limited in this application. In some embodiments, the doping type of the semiconductor pillar 1 in which the first channel 131 is located may be the same as the doping type of the semiconductor pillar 1 in which the second channel 132 is located. For example, the doping type of the first doped region 11 and the doping type of the second doped region 12 each may be N-type doping, and correspondingly, the doping type of the semiconductor pillar 1 in which the first channel 131 is located and the doping type of the semiconductor pillar 1 in which the second channel 132 is located each may be P-type doping.

In addition, a doping concentration of the first channel 131 and a doping concentration of the second channel 132 are not specifically limited in this application, either. In some embodiments, the doping concentration of the first channel 131 may be the same as or close to the doping concentration of the second channel 132.

Further referring to FIG. 4b and FIG. 4c, in some embodiments, the channel region 13 may further include an isolation channel 133.

The isolation channel 133 is located between the first channel 131 and the second channel 132. The isolation channel 133 may be configured to isolate the first inversion layer 141 and the second inversion layer 142.

A disposition manner of the isolation channel 133 is not specifically limited in this application. In some embodiments, as shown in FIG. 4b, the isolation channel 133 may extend in a direction parallel to the first direction (e.g., the X direction).

In an example, the isolation channel 133 is located between a projection of the first word line 21 in the channel region 13 toward the substrate and a projection of the second word line 22 in the channel region 13 toward the substrate. In an example, as shown in FIG. 4b, the isolation channel 133 may overlap the projection of the first word line 21 in the channel region 13 toward the substrate and/or the projection of the second word line 22 in the channel region 13 toward the substrate. To be specific, the isolation channel 133 overlaps the projection of the first word line 21 in the channel region 13 toward the substrate, or the isolation channel 133 overlaps the projection of the second word line 22 in the channel region 13 toward the substrate, or the isolation channel 133 overlaps both the projection of the first word line 21 in the channel region 13 toward the substrate and the projection of the second word line 22 in the channel region 13 toward the substrate.

In some other embodiments, as shown in FIG. 4c, the isolation channel 133 may alternatively extend in a direction intersecting the first direction (e.g., the X direction).

In some embodiments, the isolation channel 133 may include a first-side end surface and a second-side end surface disposed opposite to each other in the extension direction of the isolation channel 133.

For example, the first-side end surface is located on a side of the first channel 131 close to the second channel 132, and the first-side end surface is located outside the projection of the first word line 21 in the channel region 13 toward the substrate, and the second-side end surface is located on a side of the second channel 132 close to the first channel 131, and the second-side end surface is located outside the projection of the second word line 22 in the channel region 13 toward the substrate.

A doping type of a semiconductor pillar 1 in which the isolation channel 133 is located is not specifically limited in this application. In some embodiments, all of the doping type of the semiconductor pillar 1 in which the first channel 131 is located, the doping type of the semiconductor pillar 1 in which the second channel 132 is located, and the doping type of the semiconductor pillar 1 in which the isolation channel 133 is located are the same. For example, the doping type of the semiconductor pillar 1 in which the first channel 131 is located, the doping type of the semiconductor pillar 1 in which the second channel 132 is located, and the doping type of the semiconductor pillar 1 in which the isolation channel 133 is located each are P-type doping.

In addition, a doping concentration of the isolation channel 133 is not specifically limited in this application, either. In some embodiments, the doping concentration of the isolation channel 133 may be less than the doping concentration of the first channel 131 and less than the doping concentration of the second channel 132.

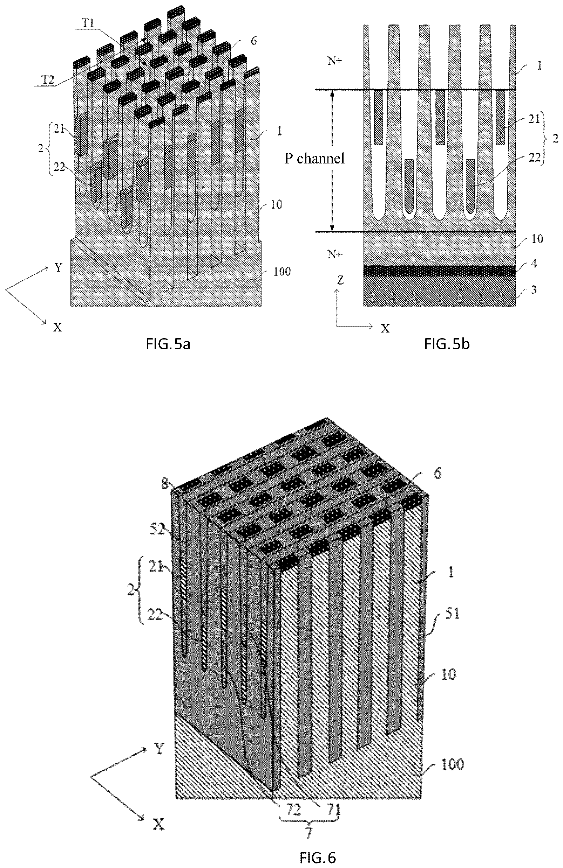

Referring to FIG. 5a, FIG. 5b, and FIG. 6, in some other embodiments, the semiconductor structure may include a semiconductor layer 100, multiple bit lines 3 extending in the first direction (e.g., the X direction) and being spaced apart in the second direction (e.g., the Y direction), and multiple word lines 2 extending in the second direction (e.g., the Y direction) and being spaced apart in the first direction (e.g., the X direction).

It should be noted that in this embodiment of this application, the second direction intersects the first direction.

The semiconductor layer 100 has first isolation trenches T1 extending in the first direction (e.g., the X direction) and second isolation trenches T2 extending in the second direction (e.g., the Y direction). The first isolation trenches T1 may isolate multiple semiconductor strips 10 spaced apart in the second direction (e.g., the Y direction) in the semiconductor layer 100, and the second isolation trenches T2 may isolate multiple semiconductor pillars 1 spaced apart in the first direction (e.g., the X direction) in the semiconductor strips 10. Specifically, the depth of the first isolation trench T1 should be greater than the depth of the second isolation trench T2.

The bit line 3 is located on a bottom surface of a corresponding semiconductor strip 10. The word line 2 is located in a corresponding second isolation trench T2. In addition, the multiple word lines 2 and the multiple semiconductor pillars 1 are alternately arranged in the first direction (e.g., the X direction), and two word lines 2 on two opposite sidewalls of the same semiconductor pillar 1 are staggered in an extension direction of the semiconductor pillar 1, and jointly constitute a control word line 2 corresponding to the semiconductor pillar 1.

In the semiconductor structure provided in the foregoing embodiment, the two word lines 2 on the two opposite sidewalls of the semiconductor pillar 1 are staggered while the two word lines 2 are enabled to jointly constitute the control word line 2 corresponding to the semiconductor pillar 1, so that space between adjacent semiconductor pillars 1 can be reduced, thereby reducing the volume of the device.

In addition, in the semiconductor structure, ends of the semiconductor pillars 1 connected to the bit lines 3 are shorted together, so that the volume of the device can be further reduced, and a contact resistance between the bit line 3 and the semiconductor pillar 1 can also be reduced.

In addition, the second isolation trench T2 in the semiconductor structure is shallower than a trench in a conventional semiconductor structure. Therefore, the difficulty of a manufacturing process can be further reduced.

The material of the semiconductor layer 100 is not specifically limited in this application. In an example, the material of the semiconductor layer 100 may include but is not limited to silicon (Si), silicon germanium (SiGe), silicon germanium carbon (SiGeC), silicon carbide (SiC), gallium arsenide (GaAs), indium arsenide (InAs), indium phosphide (InP), or the like; or the material of the semiconductor layer 100 may include silicon on insulator (SOI) or silicon-germanium on insulator.

The material of the bit line 3 is not specifically limited in this application. In an example, the material of the bit line 3 may include but is not limited to doped polysilicon, titanium (Ti), titanium nitride (TiN), tungsten (W), or the like.

The material of the word line 2 is not specifically limited in this application. In an example, the material of the word line 2 may include tungsten (W), copper (Cu), titanium (Ti), tantalum (Ta), titanium nitride (TiN), tantalum nitride (TaN), a metal silicide, a metal alloy, or any combination thereof.

A location relationship between the bit line 3 and the semiconductor strip 10 is not specifically limited in this application. In some embodiments, as shown in FIG. 5b, an orthographic projection of the bit line 3 on the semiconductor layer 100 may overlap the semiconductor strip 10; or an orthographic projection of the bit line 3 on the semiconductor layer 100 may approximately overlap the semiconductor strip 10.

Further referring to FIG. 5a, FIG. 5b, and FIG. 6, in the two word lines 2 corresponding to the same semiconductor pillar 1, a word line 2 close to a bottom portion of the second isolation trench T2 serves as a second word line 22, and a word line 2 away from the bottom portion of the second isolation trench T2 serves as a first word line 21.

A top surface of the second word line 22 may be flush with a bottom surface of the first word line 21; or a top surface of the second word line 22 may be lower than a bottom surface of the first word line 21.

The width of the second word line 22 is not specifically limited in this application. In some embodiments, the width of the second word line 22 may gradually increase in a direction away from the bottom portion of the second isolation trench T2.

It should be noted that in this application, the width of the second word line 22 refers to the size of the second word line 22 in the first direction (e.g., the X direction).

The shape of the second word line 22 is not specifically limited in this application. In some embodiments, the shape of an end portion of the second word line 22 close to the bottom portion of the second isolation trench T2 may be similar to that of the bottom portion of the second isolation trench T2.

Further referring to FIG. 6, in some embodiments, the semiconductor structure may further include an air gap structure 7.

The air gap structure 7 is located in the second isolation trench T2, and the air gap structure 7 may include a first air gap 71 and/or a second air gap 72. The first air gap 71 is located above the second word line 22, and the second air gap 72 is located below the first word line 21.

In the semiconductor structure provided in the foregoing embodiment, the air gap structure 7 in the second isolation trench T2 can reduce a floating body effect between adjacent semiconductor pillars 1, to further reduce static leakage of the device in a use process.

In addition, because the dielectric constant of air is 1.001, and is close to the dielectric constant of a vacuum, forming the air gap structure 7 in the second isolation trench T2 in the semiconductor structure provided in the foregoing embodiment can further enable an upper region of the second word line 22 and a lower region of the first word line 21 to be presented as a low-dielectric-constant material, thereby reducing an overall dielectric constant. In this way, the magnitude of a parasitic capacitance can be reduced, so that impact on a performance parameter of the device caused by the parasitic capacitance is reduced.

The shape of the air gap structure 7 is not specifically limited in this application. In an example, the shape of the air gap structure 7 may include an elongated shape (air line), a short-pipe shape (air pipe), an elliptical shape (air gap), or another suitable shape.

The location of the first air gap 71 is not specifically limited in this application, provided that the first air gap 71 is located above the second word line 22. In some embodiments, an orthographic projection of the first air gap 71 on the semiconductor pillar 1 may overlap or approximately overlap an orthographic projection of the first word line 21 on the semiconductor pillar 1.

The location of the second air gap 72 is not specifically limited in this application, either, provided that the second air gap 72 is located below the first word line 21. In some embodiments, an orthographic projection of the second air gap 72 on the semiconductor pillar 1 may overlap or approximately overlap an orthographic projection of the second word line 22 on the semiconductor pillar 1.

Further referring to FIG. 6, in some embodiments, the semiconductor structure may further include a first isolation structure 51 and a second isolation structure 52.

The first isolation structure 51 is located in the first isolation trench T1, and may be configured to fill a spacing between adjacent semiconductor strips 10. The second isolation structure 52 is located in the second isolation trench T2, and may be configured to fill a spacing between adjacent semiconductor pillars 1 in the first direction (e.g., the X direction) and cover the word line 2. In addition, the second isolation structure 52 may be further configured to seal the air gap structure 7.

The materials of the first isolation structure 51 and the second isolation structure 52 are not specifically limited in this application. In an example, the material of the first isolation structure 51 may be the same as the material of the second isolation structure 52. In this case, the first isolation structure 51 and the second isolation structure 52 may actually be presented as an integral structure.

In some embodiments, the material of the first isolation structure 51 and the material of the second isolation structure 52 each may include but are not limited to silicon nitride (SiN), silicon oxynitride (SiON), silicon dioxide (SiO₂), or the like, or a combination thereof.

A location relationship between the first air gap 71 and the first word line 21 is not specifically limited in this application. In some embodiments, a bottom surface of the first air gap 71 may be flush with the bottom surface of the first word line 21; or a bottom surface of the first air gap 71 may be lower than the bottom surface of the first word line 21.

In some embodiments, a top surface of the first air gap 71 may be flush with a top surface of the first word line 21; or a top surface of the first air gap 71 may be higher than a top surface of the first word line 21.

A location relationship between the second air gap 72 and the second word line 22 is not specifically limited in this application. In some embodiments, a top surface of the second air gap 72 may be flush with the top surface of the second word line 22; or a top surface of the second air gap 72 may be higher than the top surface of the second word line 22.

In some embodiments, a bottom surface of the second air gap 72 may be flush with the bottom surface of the second word line 22.

Further referring to FIG. 5b, in some embodiments, the semiconductor structure may further include a bit line contact structure 4. The bit line contact structure 4 may be located between the bit line 3 and the semiconductor strip 10, and the semiconductor strip 10 may be connected to the bit line 3 through the bit line contact structure 4.

Further referring to FIG. 6, in some embodiments, the semiconductor structure may further include a gate dielectric layer 8. The gate dielectric layer 8 may cover a sidewall of the semiconductor pillar 1 in the first direction (e.g., the X direction), and is located between the semiconductor pillar 1 and the word line 2.

The material of the gate dielectric layer 8 is not specifically limited in this application. In an example, the material of the gate dielectric layer 8 may include but is not limited to one or more of a high-K dielectric material, silicon oxide, silicon nitride, or silicon oxynitride. The high-K dielectric material is a material whose relative dielectric constant is greater than a relative dielectric constant of silicon oxide, e.g., hafnium oxide (HfO₂) or aluminum oxide (Al₂O₃).

It should be noted that in some embodiments, the material of the gate dielectric layer 8 may be the same as the material of the first isolation structure 51 and/or the material of the second isolation structure 52. When the material of the gate dielectric layer 8 is the same as both the material of the first isolation structure 51 and the material of the second isolation structure 52, the gate dielectric layer 8, the first isolation structure 51, and the second isolation structure 52 may actually be presented as an integral structure.

The structure of the gate dielectric layer 8 is not specifically limited in this application, either. In an example, the gate dielectric layer 8 may be of a single-layer structure, or may be of a stacked structure. In addition, the quantity of layers of the gate dielectric layer 8 may be adaptively set based on different actual manufacturing processes and different requirements on the thickness of the gate dielectric layer 8.

With regard to the feasibility of the performance of the semiconductor structure provided in this application, it may be verified through technology computer aided design (TCAD) simulation, that the semiconductor structure provided in this application is indeed feasible.

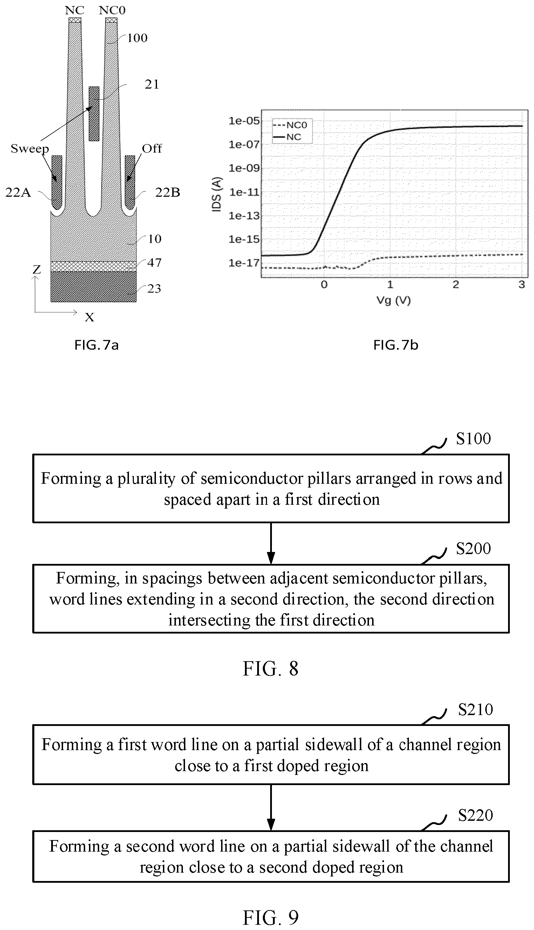

As shown in FIG. 7a and FIG. 7b, a device located on the left side is turned on when a second word line 22A and the first word line 21 located on the left side are swept (Sweep). In this case, the second word line 22B located on the right side remains in an off (Off) state, and a leakage current of a device located on the right side may remain below 0.1 FA. FIG. 7b shows currents IDS flowing through storage nodes NC and NC0 corresponding to the two devices. Vg is a voltage applied to the storage node, and IDS is the current flowing through the storage node.

It can be learned that in the side-gate transistor device provided in the foregoing embodiment, sweeping only the second word line 22A or sweeping only the first word line 21 is not enough to turn on a corresponding side-gate transistor, so that interference between adjacent side-gate transistors is reduced, thereby reducing impact on a charging/discharging speed of the side-gate transistor device caused by a parasitic capacitance and increasing a storage speed of the side-gate transistor device.

In some embodiments, the semiconductor structure may further include multiple capacitor units. In an example, the multiple capacitor units may be separately disposed above the semiconductor pillars 1.

In some embodiments, a capacitor contact structure may be disposed on the semiconductor pillar 1 through alignment, so that contact between the capacitor unit and a corresponding semiconductor pillar 1 is improved.

None of the size of the semiconductor pillar 1, the size of the word line 2, and the size of the gate dielectric layer is specifically limited in this application. In an example, the size of the semiconductor pillar 1 may be 6 nm to 10 nm. For example, the size of the semiconductor pillar 1 may be 6 nm, 7 nm, 8 nm, 9 nm, or 10 nm. In an example, the size of the word line 2 may be 3 nm to 7 nm. For example, the size of the word line 2 may be 3 nm, 4 nm, 5 nm, 6 nm, or 7 nm. In an example, the size of the gate dielectric layer may be 2 nm to 6 nm. For example, the size of the gate dielectric layer may be 2 nm, 3 nm, 4 nm, 5 nm, or 6 nm.

It should be noted that the size of the semiconductor pillar 1 refers to the width of the semiconductor pillar 1 in the first direction (e.g., the X direction), the size of the word line 2 refers to the width of the word line 2 in the first direction (e.g., the X direction), and the size of the gate dielectric layer refers to the thickness of the gate dielectric layer.

In an example, in the semiconductor structure provided in this embodiment of this application, for a semiconductor pillar 1 and two word lines 2 corresponding to the semiconductor pillar 1, a required space size (also referred to as Pitch) may be calculated in the following manner. In an example in which the size of the semiconductor pillar 1 is 8 nm, the size of the word line 2 is 5 nm, and the size of the gate dielectric layer is 4 nm, Pitch=8 nm+4 nm*2+5 nm*2=21 nm. In this way, a storage cell area (also referred to as Unit AA Area) is Unit AA Area=21 nm*21 nm=0.44 nm², and the storage cell area is approximately one third of 1C nm process. It can be learned that the volume of the semiconductor structure is relatively small, which facilitates miniaturization of the size of the device.

According to another aspect, this application further provides a manufacturing method for a semiconductor structure according to some embodiments.

Referring to FIG. 8, in some embodiments, the manufacturing method for a semiconductor structure may include the steps as follows.

In the step of S100, multiple semiconductor pillars 1 arranged in rows and spaced apart in a first direction are formed.

In the step of S200, word lines 2 extending in a second direction are formed in spacings between adjacent semiconductor pillars 1. The second direction intersects the first direction.

The multiple word lines 2 and the multiple semiconductor pillars 1 are alternately arranged in the first direction, and two word lines 2 located on two sides of the same semiconductor pillar 1 are staggered in an extension direction of the semiconductor pillar 1, and jointly constitute a control word line corresponding to the semiconductor pillar 1.

In the manufacturing method for a semiconductor structure provided in the foregoing embodiment, the two staggered word lines 2 are formed on two opposite sidewalls of the semiconductor pillar 1 while the two word lines 2 are enabled to jointly constitute the control word line corresponding to the semiconductor pillar 1, so that space between adjacent semiconductor pillars 1 can be reduced, thereby reducing the volume of a device.

For ease of description, as shown in FIG. 1a, in this embodiment of this application, two word lines 2 located on two sides of the same semiconductor pillar 1 may be defined as a first word line 21 and a second word line 22 respectively.

Specifically, in the manufacturing method for a semiconductor structure provided in the foregoing embodiment, adjacent semiconductor pillars 1 may share the same first word line 21 or second word line 22 while the first word line 21 or the second word line 22 is enabled to be a part of a control word line corresponding to the semiconductor pillar 1, so that space between adjacent semiconductor pillars 1 can be reduced, thereby reducing the volume of the device. In addition, the disposition manner in which adjacent semiconductor pillars 1 share the same first word line 21 or second word line 22 can further make the internal layout of the semiconductor structure more proper, so that the storage density of the semiconductor structure is effectively increased.

A manner of forming the multiple semiconductor pillars 1 in the step of S100 is not specifically limited in this application. In an example, the multiple semiconductor pillars 1 may be formed in the following manner. For example,
a substrate is provided, and the multiple semiconductor pillars 1 arranged in rows and spaced apart in the first direction are formed in the substrate through a self-aligned double patterning (SADP) process, a self-aligned quadruple patterning (SAQP) process, or another suitable alignment process.

With reference to FIG. 3, it may be understood that in some embodiments, the semiconductor pillar 1 may specifically include a channel region 13 and a first doped region 11 and a second doped region 12 respectively disposed at the upper end and the lower end of the channel region 13 in the extension direction.

Referring to FIG. 9, in some embodiments, the step of S200 in which word lines 2 extending in a second direction are formed in spacings between adjacent semiconductor pillars 1 may specifically include the steps as follows.

In the step of S210, the first word line 21 is formed on a partial sidewall of the channel region 13 close to the first doped region 11.

In the step of S220, the second word line 22 is formed on a partial sidewall of the channel region 13 close to the second doped region 12.

With reference to FIG. 4a, FIG. 4b, and FIG. 4c, it may be understood that in some embodiments, the channel region 13 may specifically include a first channel 131 close to the first doped region 11 and connected to the first doped region 11 and a second channel 132 located between the first channel 131 and the second doped region 12 and connected to the second doped region 12.

In some embodiments, the step of S210 in which the first word line 21 is formed on a surface of a partial sidewall of the channel region 13 close to the first doped region 11 may specifically include the step as follows.

The first word line 21 is formed on a first-side sidewall of the first channel 131. A part of the first channel 131 close to the first-side sidewall is capable of forming a first inversion layer 141 in response to an electrical signal of the first word line 21.

In some embodiments, the step of S220 in which the second word line 22 is formed on a partial sidewall of the channel region 13 close to the second doped region 12 may specifically include the step as follows.

The second word line 22 is formed on a second-side sidewall of the second channel 132. A part of the second channel 132 close to the second-side sidewall is capable of forming a second inversion layer 142 in response to an electrical signal of the second word line 22.

It should be noted that in the manufacturing method for a semiconductor structure provided in the foregoing embodiment, the first channel 131 may not overlap the second channel 132.

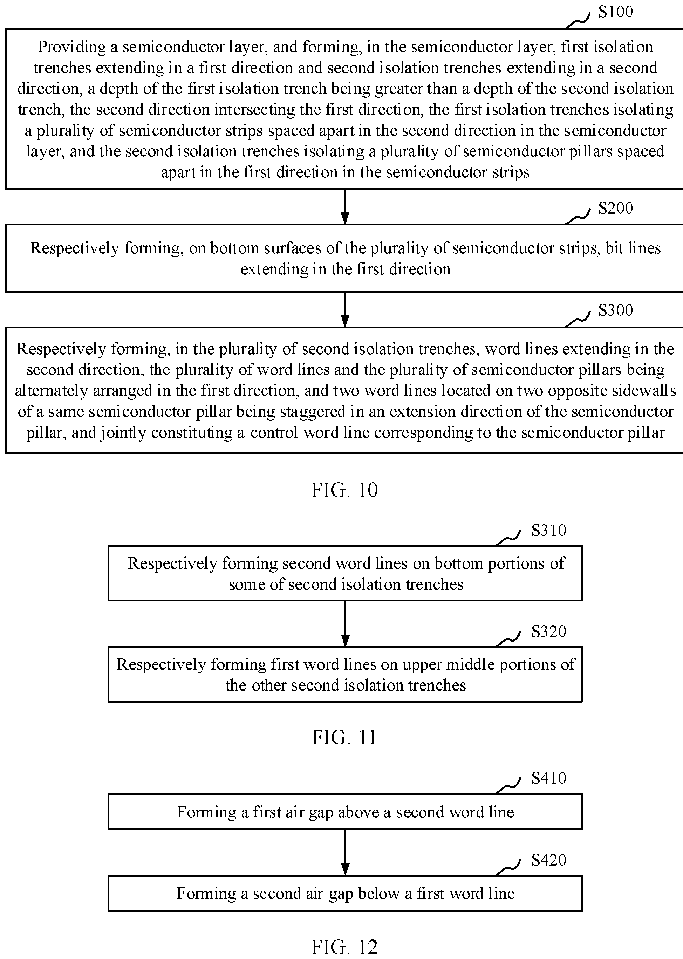

Referring to FIG. 10, in some other embodiments, the manufacturing method for a semiconductor structure may include the steps as follows.

In the step of S100, a semiconductor layer is provided, and first isolation trenches extending in a first direction and second isolation trenches extending in a second direction are formed in the semiconductor layer. The depth of the first isolation trench is greater than the depth of the second isolation trench, the second direction intersects the first direction, the first isolation trenches isolate multiple semiconductor strips spaced apart in the second direction in the semiconductor layer, and the second isolation trenches isolate multiple semiconductor pillars spaced apart in the first direction in the semiconductor strips.

In the step of S200, bit lines extending in the first direction are respectively formed on bottom surfaces of the multiple semiconductor strips.

In the step of S300, word lines extending in the second direction are respectively formed in the multiple second isolation trenches. The multiple word lines and the multiple semiconductor pillars are alternately arranged in the first direction, and two word lines located on two opposite sidewalls of the same semiconductor pillar are staggered in an extension direction of the semiconductor pillar, and jointly constitute a control word line corresponding to the semiconductor pillar.

In the manufacturing method for a semiconductor structure provided in the foregoing embodiment, the two staggered word lines may be formed on the two opposite sidewalls of the semiconductor pillar while the two word lines are enabled to jointly constitute the control word line corresponding to the semiconductor pillar, so that space between adjacent semiconductor pillars can be reduced, thereby reducing the volume of a device.

In addition, in the manufacturing method, ends of the semiconductor pillars connected to the bit lines are shorted together, so that the volume of the device can be further reduced, and a contact resistance between the bit line and the semiconductor pillar can also be reduced.

In addition, the second isolation trench formed in the manufacturing method is shallower than a trench in a conventional semiconductor structure. Therefore, the difficulty of a manufacturing process can be further reduced.

Referring to FIG. 11, in some other embodiments, the step of S300 in which word lines extending in the second direction are respectively formed in the multiple second isolation trenches may specifically include the steps as follows.

In the step of S310, second word lines are respectively formed on bottom portions of some of the second isolation trenches.

In the step of S320, first word lines are respectively formed on upper middle portions of the other second isolation trenches.

A top surface of the second word line is flush with or lower than a bottom surface of the first word line.

In some embodiments, before the second isolation trenches are formed in the semiconductor layer, the manufacturing method for a semiconductor structure may further include the step as follows. A first isolation structure is formed in the first isolation trench. The first isolation structure fills a spacing between adjacent semiconductor strips.

After the word lines are formed in the second isolation trenches, the manufacturing method for a semiconductor structure may further include the step as follows. A second isolation structure is formed in the second isolation trench. The second isolation structure fills a spacing between adjacent semiconductor pillars in the first direction and covers the word line.

Referring to FIG. 12, in some embodiments, that a second isolation structure is formed in the second isolation trench may specifically include the steps as follows.

In the step of S410, a first air gap is formed above the second word line.

In the step of S420, a second air gap is formed below the first word line.

The first air gap and the second air gap jointly constitute an air gap structure, and the second isolation structure further seals the air gap structure.

In some embodiments, before the bit lines extending in the first direction are respectively formed on the bottom surfaces of the multiple semiconductor strips, the manufacturing method for a semiconductor structure may further include the step as follows.

Bit line contact structures extending in the first direction are respectively formed on the bottom surfaces of the multiple semiconductor strips. The bit line may be formed on a bottom surface of the bit line contact structure.

In some embodiments, before the word lines extending in the second direction are respectively formed in the multiple second isolation trenches, the manufacturing method for a semiconductor structure may further include the step as follows.

A gate dielectric layer covering a sidewall of the semiconductor pillar in the first direction is formed. The word line may be formed on a sidewall of the gate dielectric layer away from the semiconductor pillar.

It should be understood that although the steps in the flowcharts of FIG. 8 to FIG. 12 are sequentially shown according to indications of the arrows, these steps are not necessarily sequentially performed according to the indications of the arrows. Unless expressly stated in the specification, these steps are not performed in a strict order, and these steps may be performed in another order. In addition, at least some steps in FIG. 8 to FIG. 12 may include multiple steps or multiple phases. These steps or phases are not necessarily performed and completed at the same moment, but may be performed at different moments. These steps or phases are not necessarily sequentially performed, but may be performed in turn or alternately with another step or at least some of the steps or phases in the another step.

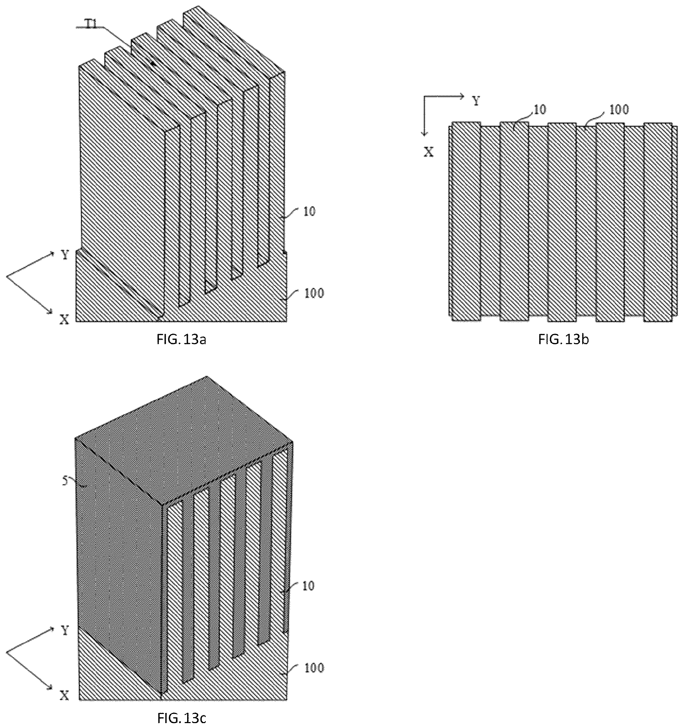

To more clearly describe the manufacturing method in the foregoing some embodiments, the some embodiments of this application are understood below with reference to FIG. 13 to FIG. 16. It should be noted that in this embodiment of this application, the second direction intersects the first direction.

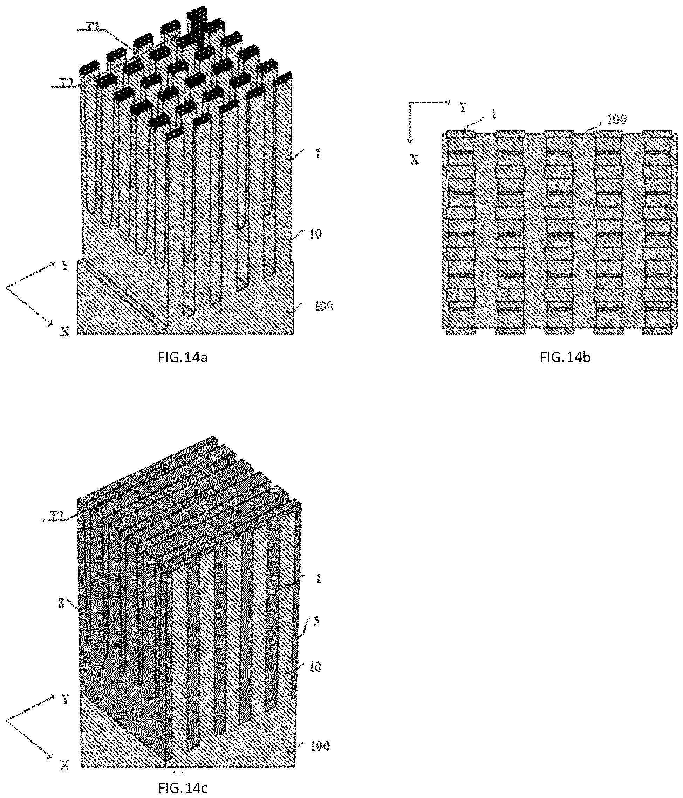

In the step of S 100, a semiconductor layer 100 is provided. As shown in FIG. 13a and FIG. 13b, first isolation trenches T1 extending in the first direction (e.g., the X direction) are formed in the semiconductor layer 100, and the first isolation trenches T1 may isolate multiple semiconductor strips 10 spaced apart in the second direction (e.g., the Y direction) in the semiconductor layer 100. As shown in FIG. 14a and FIG. 14b, second isolation trenches T2 extending in the second direction (e.g., the Y direction) are formed in the semiconductor layer 100, and the second isolation trenches T2 may isolate multiple semiconductor pillars 1 spaced apart in the first direction (e.g., the X direction) in the semiconductor strips 10.

The depth of the first isolation trench T1 is greater than the depth of the second isolation trench T2.

Manners of forming the first isolation trench T1 and the second isolation trench T2 are not specifically limited in this application. In an example, the first isolation trench T1 and the second isolation trench T2 may be formed in the semiconductor layer 100 through, but not limited to, the self-aligned double patterning (SADP) process or the self-aligned quadruple patterning (SAQP) process.

Referring to FIG. 14c, in some embodiments, before the second isolation trenches T2 are formed in the semiconductor layer 1, the manufacturing method for a semiconductor structure may further include the step as follows.

A first isolation structure 51 is formed in the first isolation trench T1. The first isolation structure 51 may be configured to fill a spacing between adjacent semiconductor strips 10.

A manner of forming the first isolation structure 51 is not specifically limited in this application. In an example, the first isolation structure 5 may be formed in the first isolation trench T1 through, but not limited to, a physical vapor deposition (PVD) process, a chemical vapor deposition (CVD) process, or an atomic layer deposition (ALD) process.

In the step of S200, bit lines extending in the first direction (e.g., the X direction) are respectively formed on bottom surfaces of the multiple semiconductor strips 10.

A manner of forming the bit line is not specifically limited in this application. In an example, the bit line may be formed on the bottom surface of the semiconductor strip 10 through, but not limited to, a heterogeneous integration technology on chip (HITOC) process.

Referring to FIG. 14c, in some embodiments, the manufacturing method for a semiconductor structure may further include the step as follows. A gate dielectric layer 8 covering a sidewall of the semiconductor pillar 100 in the first direction (e.g., the X direction) is formed.

A manner of forming the gate dielectric layer 8 is not specifically limited in this application. In an example, the gate dielectric layer 8 may be formed on a sidewall of the semiconductor pillar 1 through, but not limited to, the atomic layer deposition process, the chemical vapor deposition process, or a rapid thermal oxidation (RTO) process.

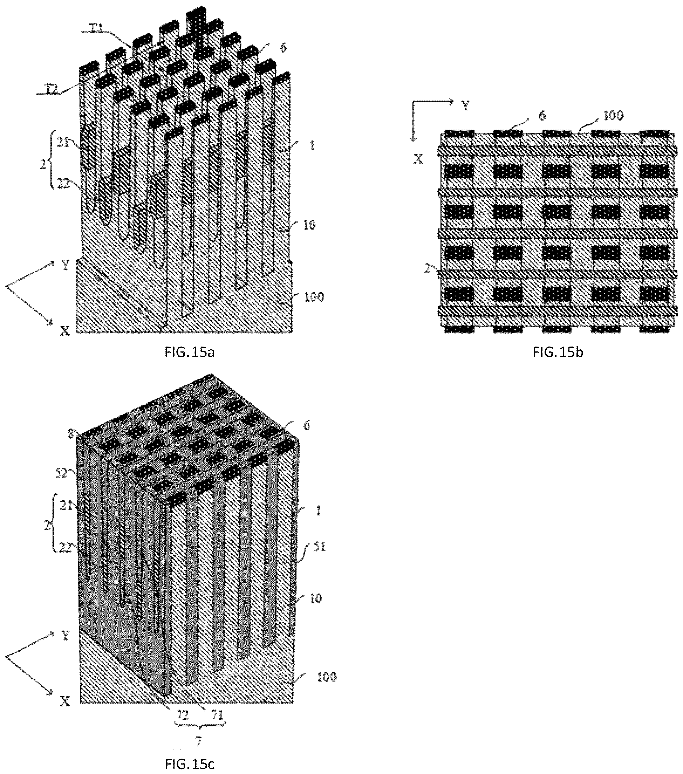

Referring to FIG. 15a, FIG. 15b, and FIG. 15c, in the step of S300, word lines 2 extending in the second direction (e.g., the Y direction) are respectively formed in the multiple second isolation trenches T2. The multiple word lines 2 and the multiple semiconductor pillars 1 are alternately arranged in the first direction (e.g., the X direction), and two word lines 2 on two opposite sidewalls of the same semiconductor pillar 1 are staggered in an extension direction of the semiconductor pillar 1, and jointly constitute a control word line 2 corresponding to the semiconductor pillar 1.

It should be noted that in some embodiments, the step of S300 may be performed after the gate dielectric layer 8 covering the sidewall of the semiconductor pillar 1 in the first direction (e.g., the X direction) is formed. In an example, the word line 2 may be formed on a sidewall of the gate dielectric layer 8 away from the semiconductor pillar 1.

Further referring to FIG. 15c, in some embodiments, after the word lines 3 are formed in the second isolation trenches T2 in the step of S300, the manufacturing method for a semiconductor structure may further include the step as follows.

A second isolation structure 52 is formed in the second isolation trench T2. The second isolation structure 52 may be configured to fill a spacing between adjacent semiconductor pillars 1 in the first direction (e.g., the X direction), and may be further configured to cover the word line 2.

A manner of forming the second isolation structure 52 is not specifically limited in this application. In an example, the second isolation structure 52 may be formed in the second isolation trench T2 through, but not limited to, the physical vapor deposition process, the chemical vapor deposition process, or the atomic layer deposition process.

With reference to FIG. 15a, FIG. 15b, and FIG. 15c, some embodiments of this application are further described below in detail by using an example in which in the two word lines 2 corresponding to the same semiconductor pillar 1, a word line 2 close to a bottom portion of the second isolation trench T2 is a second word line 22, and a word line 2 away from the bottom portion of the second isolation trench T2 is a first word line 21.

As shown in FIG. 15a, FIG. 15b, and FIG. 15c, in some embodiments, the step of S300 in which word lines 2 extending in the second direction (e.g., the Y direction) are respectively formed in the multiple second isolation trenches T2 may be specifically represented as the steps of S310 and S320 as follows.

In the step of S310, second word lines 22 are respectively formed on bottom portions of some of the second isolation trenches T2.

In the step of S320, first word lines 21 are respectively formed on upper middle portions of the other second isolation trenches T2.

In an example, a top surface of the second word line 22 may be flush with a bottom surface of the first word line 21; or a top surface of the second word line 22 may be lower than a bottom surface of the first word line 21.

Further referring to FIG. 15c, in some embodiments, that a second isolation structure 52 is formed in the second isolation trench T2 may further include the steps of S410 and S420 as follows.

In the step of S410, a first air gap 71 is formed above the second word line 22.

In the step of S420, a second air gap 72 is formed below the first word line 21.

The first air gap 71 and the second air gap 72 may jointly constitute an air gap structure 7, and the second isolation structure 52 may be configured to seal the air gap structure 7.

In the manufacturing method for a semiconductor structure provided in the foregoing embodiment, the air gap structure 7 may be formed in the second isolation trench T2 through the second isolation structure 52, and the air gap structure 7 can reduce a floating body effect between adjacent semiconductor pillars 1, to further reduce static leakage of the device in a use process.

In addition, because the dielectric constant of air is 1.001, and is close to the dielectric constant of a vacuum, forming the air gap structure 7 in the second isolation trench T2 in the manufacturing method can further enable an upper region of the second word line 22 and a lower region of the first word line 21 to be presented as a low-dielectric-constant material, thereby reducing an overall dielectric constant. In this way, the magnitude of a parasitic capacitance can be reduced, and a capacitance coupling effect between the word line 2 and an adjacent word line 2 can be avoided, so that impact on a performance parameter of the device caused by the parasitic capacitance is reduced.

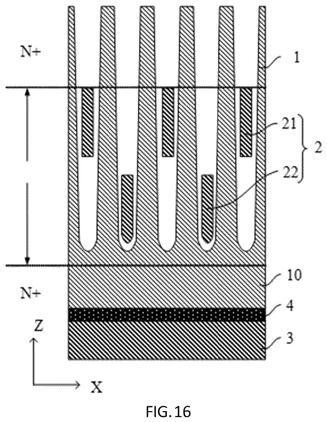

Referring to FIG. 16, in some embodiments, before the bit lines 3 extending in the first direction (e.g., the X direction) are respectively formed on the bottom surfaces of the multiple semiconductor strips 10 in the step of S200, the manufacturing method for a semiconductor structure may further include the step as follows.

Bit line contact structures 4 extending in the first direction (e.g., the X direction) are respectively formed on the bottom surfaces of the multiple semiconductor strips 10.

In an example, as shown in FIG. 15, the bit line 3 may be formed on a bottom surface of the bit line contact structure 4.

In some embodiments, the manufacturing method for a semiconductor structure may further include the step as follows. A capacitor unit is formed above the semiconductor pillar 1.

It should be noted that the manufacturing methods for a semiconductor structure in the embodiments of this application may be utilized to manufacture corresponding semiconductor structures. Therefore, the technical features between the method embodiments and the structure embodiments may be replaced and supplemented with each other when there is no conflict, so that a person skilled in the art can learn of the technical content of this application.

The technical features in the foregoing embodiments may be combined arbitrarily. For brevity of description, not all possible combinations of these technical features in the foregoing embodiments are described. However, as long as these combinations of technical features are not contradictory, they should all be considered within the scope described in the specification.

The foregoing embodiments represent only several implementations of this application, and are described in a relatively specific and detailed way, but should not be construed as limitations on the patent scope of this application. It should be noted that a person of ordinary skill in the art can further make several variations and improvements without departing from the concept of this application, and these variations and improvements shall fall within the protection scope of this application. Therefore, the patent protection scope of this application shall be subject to the appended claims.

## Claims

1. A semiconductor structure, comprising:
a plurality of semiconductor pillars arranged in rows and spaced apart in a first direction; and
a plurality of word lines extending in a second direction and being spaced apart in the first direction, the second direction intersecting the first direction,
the plurality of word lines and the plurality of semiconductor pillars being alternately arranged in the first direction, and two word lines located on two opposite sidewalls of a same semiconductor pillar being staggered in an extension direction of the semiconductor pillar, and jointly constituting a control word line corresponding to the semiconductor pillar.

2. The semiconductor structure according to claim 1, wherein the semiconductor structure further comprises:
a semiconductor layer having first isolation trenches extending in the first direction and second isolation trenches extending in the second direction, a depth of the first isolation trench being greater than a depth of the second isolation trench, the second direction intersecting the first direction, the first isolation trenches isolating a plurality of semiconductor strips spaced apart in the second direction in the semiconductor layer, and the second isolation trenches isolating a plurality of semiconductor pillars spaced apart in the first direction in the semiconductor strips.

3. The semiconductor structure according to claim 1 or 2, wherein the semiconductor pillar comprises a channel region and a first doped region and a second doped region respectively disposed at an upper end and a lower end of the channel region in the extension direction of the semiconductor pillar.

4. The semiconductor structure according to any one of claims 1 to 3, wherein the two word lines located on two sides of the same semiconductor pillar are respectively located on sidewalls of the channel region, and projections of the two word lines in the channel region toward a substrate do not overlap.

5. The semiconductor structure according to any one of claims 1 to 4, wherein in the two word lines corresponding to the same semiconductor pillar, a word line close to a bottom portion of the second isolation trench is a second word line, and a word line away from the bottom portion of the second isolation trench is a first word line, a top surface of the second word line being flush with a bottom surface of the first word line or lower than a bottom surface of the first word line.

6. The semiconductor structure according to any one of claims 3 to 5, wherein the channel region comprises:
a first channel close to the first doped region or at least partially connected to the first doped region, the first word line being located on a first-side sidewall of the first channel, and a part of the first channel close to the first-side sidewall being capable of forming a first inversion layer in response to an electrical signal of the first word line;
a second channel close to the second doped region or at least partially connected to the second doped region, the second word line being located on a second-side sidewall of the second channel, a part of the second channel close to the second-side sidewall being capable of forming a second inversion layer in response to an electrical signal of the second word line, and the second channel not overlapping the first channel; and
an isolation channel located between the first channel and the second channel and configured to isolate the first inversion layer and the second inversion layer.

7. The semiconductor structure according to any one of claims 1 to 6, wherein there is a spacing between adjacent projection boundary lines, in the channel region toward the substrate, of the two word lines located on the two sides of the same semiconductor pillar.

8. The semiconductor structure according to claim 6 or 7, wherein an extension direction of the isolation channel is parallel to the first direction; and/or
the isolation channel is located between a projection of the first word line in the channel region toward the substrate and a projection of the second word line in the channel region toward the substrate; and/or
the isolation channel overlaps the projection of the first word line in the channel region toward the substrate and/or the projection of the second word line in the channel region toward the substrate.

9. The semiconductor structure according to any one of claims 6 to 8, wherein the extension direction of the isolation channel intersects the first direction; and/or
the isolation channel comprises a first-side end surface and a second-side end surface disposed opposite to each other in the extension direction of the isolation channel,
the first-side end surface being located on a side of the first channel close to the second channel, and the first-side end surface being located outside the projection of the first word line in the channel region toward the substrate; and
the second-side end surface being located on a side of the second channel close to the first channel, and the second-side end surface being located outside the projection of the second word line in the channel region toward the substrate.

10. The semiconductor structure according to any one of claims 6 to 9, wherein a doping type of a semiconductor pillar in which the first channel is located, a doping type of a semiconductor pillar in which the second channel is located, and a doping type of a semiconductor pillar in which the isolation channel is located are the same, a doping concentration of the semiconductor pillar in which the isolation channel is located being less than a doping concentration of the semiconductor pillar in which the first channel is located and less than a doping concentration of the semiconductor pillar in which the second channel is located.

11. The semiconductor structure according to any one of claims 5 to 10, wherein a width of the second word line increases in a direction away from the bottom portion of the second isolation trench, and the width of the second word line is a size of the second word line in the first direction.

12. The semiconductor structure according to any one of claims 2 to 11, wherein the semiconductor structure further comprises an air gap structure located in the second isolation trench,
the air gap structure comprising:
a first air gap located above the second word line; and/or
a second air gap located below the first word line; and/or
a bottom surface of the first air gap being flush with or lower than the bottom surface of the first word line, and a top surface of the first air gap being flush with or higher than a top surface of the first word line; and
a top surface of the second air gap being flush with or higher than the top surface of the second word line, and a bottom surface of the second air gap being flush with a bottom surface of the second word line.

13. The semiconductor structure according to any one of claims 1 to 12, wherein the semiconductor structure further comprises:
a first isolation structure located in the first isolation trench and filling a spacing between adjacent semiconductor strips; and
a second isolation structure located in the second isolation trench and filling a spacing between adjacent semiconductor pillars in the first direction and covering the word line, the second isolation structure further sealing the air gap structure.

14. The semiconductor structure according to any one of claims 1 to 13, wherein the semiconductor structure further comprises:
a plurality of bit lines extending in the first direction and being spaced apart, the bit lines being located on bottom surfaces of semiconductor pillars in a corresponding row and being connected to the semiconductor pillars, and/or
an orthographic projection of the bit line on the semiconductor layer overlapping or approximately overlapping the semiconductor strip; and
the semiconductor structure further comprises:
a bit line contact structure located between the bit line and the semiconductor strip,
the semiconductor strip being connected to the bit line through the bit line contact structure; and/or
a gate dielectric layer covering a sidewall of the semiconductor pillar and being located between the semiconductor pillar and the word line.

15. A manufacturing method for a semiconductor structure, comprising:
providing a semiconductor layer, and forming, in the semiconductor layer, first isolation trenches extending in a first direction and second isolation trenches extending in a second direction, a depth of the first isolation trench being greater than a depth of the second isolation trench, the second direction intersecting the first direction, the first isolation trenches isolating a plurality of semiconductor strips spaced apart in the second direction in the semiconductor layer, and the second isolation trenches isolating a plurality of semiconductor pillars spaced apart in the first direction in the semiconductor strips;
respectively forming, on bottom surfaces of the plurality of semiconductor strips, bit lines extending in the first direction; and
respectively forming, in the plurality of second isolation trenches, word lines extending in the second direction, the plurality of word lines and the plurality of semiconductor pillars being alternately arranged in the first direction, and two word lines located on two opposite sidewalls of a same semiconductor pillar being staggered in an extension direction of the semiconductor pillar, and jointly constituting a control word line corresponding to the semiconductor pillar.

16. The manufacturing method for a semiconductor structure according to claim 15, wherein the semiconductor pillar comprises a channel region and a first doped region and a second doped region respectively disposed at an upper end and a lower end of the channel region in the extension direction;
the forming, in the plurality of second isolation trenches, word lines extending in the second direction comprises:
forming a first word line on a partial sidewall of the channel region close to the first doped region; and
forming a second word line on a partial sidewall of the channel region close to the second doped region;
the channel region comprises a first channel close to the first doped region and connected to the first doped region and a second channel located between the first channel and the second doped region and connected to the second doped region, the second channel not overlapping the first channel;
the forming the first word line on a partial sidewall of the channel region close to the first doped region comprises: forming the first word line on a first-side sidewall of the first channel, a part of the first channel close to the first-side sidewall being capable of forming a first inversion layer in response to an electrical signal of the first word line; and
the forming the second word line on a partial sidewall of the channel region close to the second doped region comprises: forming the second word line on a second-side sidewall of the second channel, a part of the second channel close to the second-side sidewall being capable of forming a second inversion layer in response to an electrical signal of the second word line.

17. The manufacturing method for a semiconductor structure according to claim 15, wherein in the two word lines corresponding to the same semiconductor pillar, a word line close to a bottom portion of the second isolation trench is a second word line, and a word line away from the bottom portion of the second isolation trench is a first word line; and
the respectively forming, in the plurality of second isolation trenches, word lines extending in the second direction comprises:
respectively forming second word lines on bottom portions of some of the second isolation trenches; and
respectively forming first word lines on upper middle portions of the other second isolation trenches,
a top surface of the second word line being flush with or lower than a bottom surface of the first word line.

18. The manufacturing method for a semiconductor structure according to claim 16 or 17, wherein
before the second isolation trenches are formed in the semiconductor layer, the manufacturing method for a semiconductor structure further comprises: forming a first isolation structure in the first isolation trench, the first isolation structure filling a spacing between adjacent semiconductor strips; and
after the word lines are formed in the second isolation trenches, the manufacturing method for a semiconductor structure further comprises: forming a second isolation structure in the second isolation trench, the second isolation structure filling a spacing between adjacent semiconductor pillars in the first direction and covering the word line.

19. The manufacturing method for a semiconductor structure according to claim 18, wherein the forming a second isolation structure in the second isolation trench comprises:
forming a first air gap above the second word line; and
forming a second air gap below the first word line,
the first air gap and the second air gap jointly constituting an air gap structure, and the second isolation structure further sealing the air gap structure.

20. The manufacturing method for a semiconductor structure according to any one of claims 15 to 19, wherein before the respectively forming, on bottom surfaces of the plurality of semiconductor strips, bit lines extending in the first direction, the manufacturing method for a semiconductor structure further comprises:
respectively forming, on the bottom surfaces of the plurality of semiconductor strips, bit line contact structures extending in the first direction,
the bit line being formed on a bottom surface of the bit line contact structure; and/or
before the respectively forming, in the plurality of second isolation trenches, word lines extending in the second direction, the manufacturing method for a semiconductor structure further comprises:
forming a gate dielectric layer covering a sidewall of the semiconductor pillar in the first direction,
the word line being formed on a sidewall of the gate dielectric layer away from the semiconductor pillar.
